# EUROPEAN PATENT SPECIFICATION

(11) **EP 1 386 173 B1**
(45) Date of publication and mention of the grant of the patent: **27.10.2004**
(21) Application number: 02704634.1
(22) Date of filing: 14.03.2002
(51) Int. Cl.: G01R 27/26

(54) **CAPACITANCE MEASURING CIRCUIT**
KAPAZITÄTSMESS-SCHALTUNG
CIRCUIT DE MESURE DE LA CAPACITANCE

(30) Priority: 16.03.2001 DK 200100450
(43) Date of publication of application: 04.02.2004
(73) Proprietor: EILERSEN, Nils Aage Juul, DK-2950 Vedbaek (DK)
(72) Inventor: EILERSEN, Nils Aage Juul, DK-2950 Vedbaek (DK)
(86) International application number: PCT/DK2002/000173
(87) International publication number: WO 2002/075331

(56) References cited:
- EP-A2- 0 489 259
- EP-A2- 0 969 287
- DE-C1- 4 135 990
- DE-C1- 4 135 991
- US-A- 4 347 740
- US-A- 4 737 706
- US-A- 5 136 262
- US-A- 5 148 126
- US-A- 5 424 650

## Description

The invention relates to a capacitance measuring circuit where the value of a sensor capacitance or another capacitance to be measured, is represented by a frequency output, which is an inverse function of the value of the sensor capacitance.
Measuring circuits with frequency outputs are widely used as they are easy to interface to microprocessors for further digital signal processing.
More specifically the invention relates to a capacitance measuring circuit, comprising an oscillator circuit, where the sensor capacitance forms a link of two or more series connected impedances, which is connected to the capacitance measuring circuit only at the end terminals of the series connection, and where one terminal of the sensor capacitance is an end terminal of the series connection, which is connected to a constant voltage and the other end terminal of the series connection is connected to a sensing node, which oscillates with a square wave voltage, in order to maintain constant voltage levels during each of the half-periods, and which at the same time senses the charging current flowing into the series connected impedances, to enable the capacitance measuring circuit to be triggered at the moments when the charging current thus sensed has changed to predetermined levels.

Capacitances have for many years been measured by a range of well known standard RC oscillator circuits, where the frequency is determined by measuring the charging voltage directly on the sensor capacitance and comparing it with reference voltages.
This measurement is a high impedance measurement and the standard RC oscillator circuits will be sensitive to stray capacitances, as these will appear in parallel with the sensor capacitance.
Changes in these capacitances are therefore impossible to discern from each other. The stray capacitances in the standard RC oscillator circuits comes mainly from the wires connecting the sensor capacitance to the oscillator circuit, and from the input capacitance of the oscillator circuit itself and as they often are of the same magnitude as the sensor capacitance, and not constant, they present a serious problem in practice.

In US patent 4737706, a capacitance measuring circuit of the kind, where the sensor capacitance forms a link of two or more series connected impedances, is shown.
Here the current sensing and square wave generation is performed by an operational amplifier with a feed- back resistor and the output voltage of the operational amplifier, which is a function of the charging current in the series connected impedances, is compared in a voltage comparator with a positive and a negative reference voltage during respectively the positive and the negative cycles of the oscillator.

As explained this circuit has the advantage, that errors coming from the stray capacitance of the sensing node and the stray capacitance of the connection to the sensor capacitance are reduced.
This capacitance measuring circuit functions by measuring the charging current of the sensor capacitance, through the series connected impedances, connected to the low impedance sensing node of the measuring circuit.
Hereby the high impedance of the sensor capacitance is insulated from the low impedance sensing node by the series connected impedances, which means that the influence of the stray capacitance at the sensing node and the influence of the stray capacitance of the connecting node between the sensor capacitance and the series connected impedance are separated.
By placing the series connected impedance directly at the sensor capacitor, the stray capacitance at the connecting node between the sensor capacitor and the series connected impedance may be very small, and not of any importance.
The low impedance of the sensing node will charge the stray capacitance of the sensing node fast, and long before the trigger level of the charging current is reached and therefore the influence of the stray capacitance of the sensing node is reduced.
In practice the capacitance measuring circuit according to US patent 4737706 has a number of limitations, primarily because the ability of the circuit to reduce the influence of stray capacitances is depending on a fast and very low impedance source to generate the square wave voltage, which is impressed on the series connected impedances, and a square wave voltage, generated by the output of an operational amplifier, by feed-back through a resistor, has relatively long rise times and a relatively high source impedance.
Therefore stray capacitances are only reduced to a certain degree.

Secondly the precision of the circuit relies mainly on the speed and the precision of the measurement of the charging current and its conversion into a voltage.
The input bias currents and offset voltages of the operational amplifier in the circuit according to US patent 4737706 are temperature dependent and will influence the measurement of the charging current into the series connected impedances, and temperature dependent variations in the open loop amplification factor of the operational amplifier will influence the conversion of the charging current into the output voltage presented to the voltage comparator, and at last the speed of the available operational amplifiers is limited because the output value is a voltage.
For these reasons the accuracy of the circuit according to US patent 4737706 is not ideal.

It is the object of the invention to provide an improved capacitance measuring circuit of the type initially mentioned, where a highly accurate and fast square wave voltage is impressed on the series connected impedances from a low impedance source, and where the measurement of the charging current, into the series connected impedances, is performed with a high precision, preferably by a current comparator with a low input impedance.

According to the invention this object is achieved in that the complete capacitance measuring circuit, including the sensing node, is shifted or switched alternately between two voltages.

Hereby a square wave, with the constant voltage levels in the half periods being defined by said two voltages, is impressed at that end of the series connected impedances, which is connected to the sensing node of the capacitance measuring circuit.
With fast, low impedance switches, low impedance voltage sources and a low input impedance current comparator, the circuit according to the invention generates an almost perfect square wave on the sensing node and an important condition for reducing the influence of stray capacitances is fulfilled.

By switching the complete capacitance measuring circuit, including the sensing node, between the two voltages, the sensing node of the current comparator will remain at a constant voltage in relation to the rest of the circuit, if the current measuring circuit has
a low input impedance.
This characteristic of the capacitance measuring circuit according to the invention, brings the very important advantage that the stray capacitances between the sensing node and the rest of circuit and the input capacitance of the sensing node will also have constant voltages and will therefore not be charged and discharged at each oscillation.
As these capacitances have constant voltages and charges, their value will not influence the measurement of the charging current and for the same reason the circuit is inherently very fast.

In a first preferred embodiment of the invention the series connected impedances, consists of the capacitance to be measured with one end grounded and the other end connected to the oscillating sensing node through a resistor.
This resistor will effectively insulate the high impedance of the capacitance to be measured, from the low impedance sensing node.
If the resistor is physically mounted directly on the capacitance to be measured, only the small stray capacitance of the connecting node between these two impedances has to be considered.

In a second preferred embodiment of the invention, the sensing node is the input of a current comparator.

Current comparators have generally the advantages of low input impedance and fast response, because the voltage excursions on the nodes are very low, and have the very important advantage, for the capacitance measuring circuit according to the invention, that they directly measures the charging current in the series connected impedances.

Furthermore current comparators in CMOS technology can be made very sensitive.

In a third preferred embodiment of the invention, the two voltages which define the square wave voltage, impressed on the series connected impedances, are alternately switched to one end of a resistor, which is connected to the sensing node at the other end, in order to generate the two reference currents.

Hereby a high stability is obtained as the influences from variations in the two voltages are reduced to second order effects.

In a fourth preferred embodiment of the invention the switching level of the current comparator is chosen near zero current.

Hereby the influence of the amplification factor of the current comparator, on the accuracy of the circuit, is reduced.

In a fifth embodiment of the invention, reference currents with appropriate values and polarities are generated internally in the current comparator circuit by current sources which are switched according to the polarity of the charging current in the series connected impedances.

This embodiment of the invention has the important advantage that outside electrical noise sources will not have any influence on the reference currents as they are generated internally on the chip.

In a sixth embodiment of the invention, the sensing node is connected to a plurality of series connected impedances, including a plurality of sensor capacitances, through a multiplexing circuit.

This embodiment has the advantage that several sensor capacitances are measured by the same circuit, which gives the possibility of for example using differential measuring methods.

In special cases the reference current is arranged to change according to a predetermined function of time during each half-period of the oscillation, for example by including a reactive component such as an inductor in the reference current generating circuit.

Hereby the sensitivity of the capacitance measuring circuit may be increased when the charging current is near the switching level.

The invention will now be described in further detail where,
Fig. 1 shows a preferred embodiment of the circuit according to the invention.
Fig. 2 shows the square wave voltage V1 on the sensing node Cu with respect to ground
Fig. 3 shows the charging current through the series connected impedance Rt, with the fast transitions and the exponentially changing current between the transitions.
Fig. 4 shows the current through the reference current generating impedance R1.
Fig. 5 shows the sum Ivar of the currents IRt and IR1 at the sensing node Cu.

The capacitance measuring circuit 1, which preferably is integrated on a CMOS chip, contains the current comparator 2 with the input terminal Cu, connected to the series connected impedances Rt-Ct, the switch S1 with the output terminal OF, connected to the fixed voltage Vf, and the inverted switch S2 with the output terminal VOR, connected to terminal Cu through the resistor R1.The circuit has the power supply terminals Vdd and Vss which are supplied through the resistors R2 and R3 by the voltage sources V2 and V3.
The resistors R2 and R3 will allow the complete capacitance measuring circuit 1 to be switched up and down in the voltage range between V2 and V3, when the circuit oscillates.
It is presumed that the current comparator 2 is ideal, with a very low input impedance, which means that the current sensing input Cu is at a fixed voltage V1 irrespective of the current in and out of this input, and preferably, but not necessarily, this voltage is fixed at the mean between Vdd and Vss.

It is also presumed that the current comparator switches at accurately defined currents which preferably, but not necessarily, is the same current for both positive and negative sensed currents and this current is preferably, but not necessarily zero current.
Modem CMOS current comparators have low input impedances in the range of 50 ohm, switching currents in the range of 20 pA and very short response times in the range of 5 ns, and may for all practical purposes be considered ideal.
It is also presumed that the switches S1 and S2, which could be implemented in CMOS, are ideal with a series resistance which is practically zero, compared to R2 and R3.

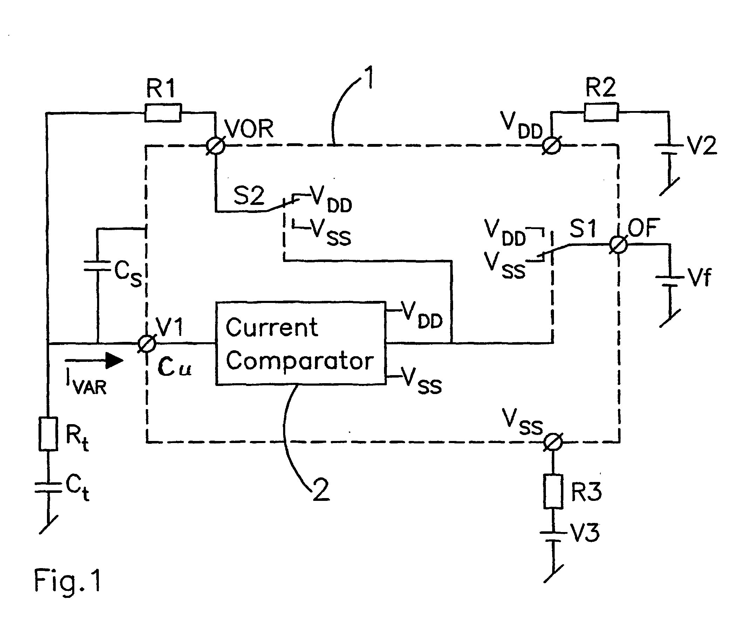

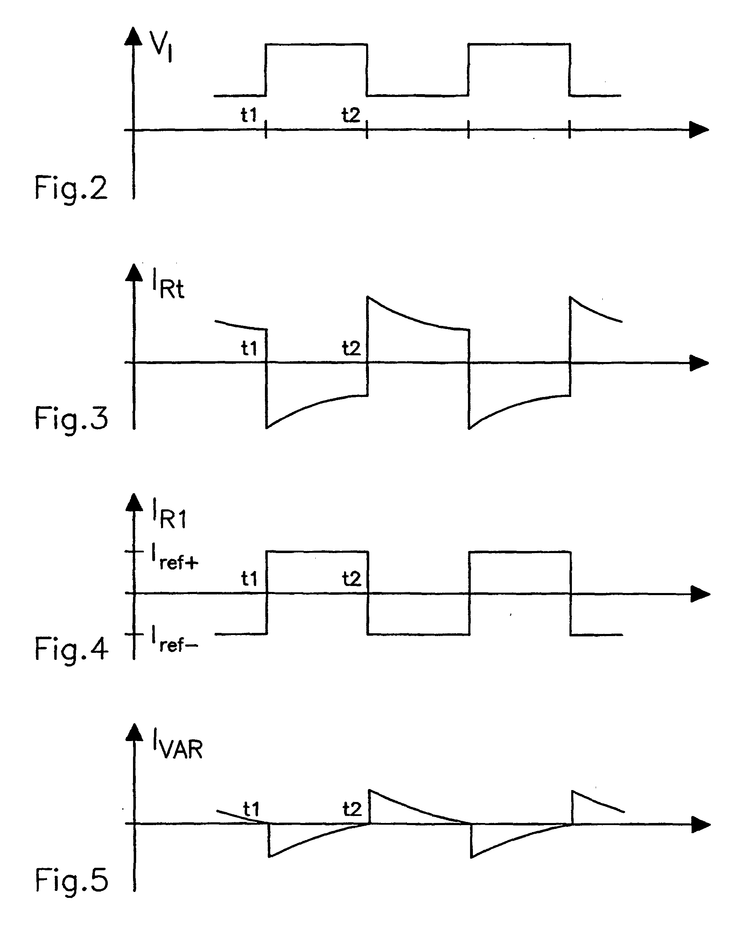

It is moreover presumed that the voltages have values which make the function of the circuit possible, typical values may be zero for V3, 8.2 V for Vf and 16.4 v for V2, both referenced to ground, -2.5 V and +2.5 V for for Vss and Vdd respectively with both referenced to V1.
The function of the capacitance measuring circuit is explained in the following with reference to fig 1 and to fig 2 to fig 5 showing the important waveforms of the circuit.

When the switch S1 at the time t1 changes from connecting OF to Vdd to connecting OF to Vss the complete circuit, including the current sensing node Cu, is lifted Vdd-Vss with respect to ground and as also Cu with the voltage V1 is subjected to the same voltage swing a current is pulled out of Cu to charge Ct through Rt, according to the well known exponential RC charging function.
At the same time switch S2 connects R1 to Vdd and a current IR1= (Vdd-V1)/R1 is impressed on Cu.

When the charging current through Rt, at the time t2 falls below the current through R1, the current at Cu changes sign and the current comparator switches S1 to connect OF to Vdd whereby the complete circuit is pulled down Vss-Vdd with respect to ground and a current is injected into Cu, when Ct is discharged through Rt, again according to the well known exponential RC charging function.
At the same time switch S2 connects R1 to Vss and a current IR1= (V1-Vss)/R1 is drawn out of Cu.

When the discharging current through Rt falls below the current through R1, the current at Cu changes sign and the current comparator switches S1 and S2 again and this way the circuit oscillates with a frequency determined by Rt, Ct and R1. The relation between the value of the sensor capacitance Ct and the frequency of the circuit is an inverse function.
Instead of switching the external resistor R1, the switch S2 or switches with the same function may, according to the invention, switch internal current sources with appropriate values and polarities which are compared in the current comparator to the charging current of the capacitance to be measured.

The output frequency of the capacitance measuring circuit according to the invention may be measured at any oscillating node of the circuit, preferably through a buffer circuit.
Due to the fact that a preferred embodiment of the invention has been illustrated and described herein, it will be apparent to those skilled in the art that modifications and improvements may be made to forms herein specifically disclosed.
Accordingly, the present invention is not to be limited to the forms which are specifically disclosed, the supply voltages, for example, may assume higher or lower values.

## Claims

1. Capacitance measuring circuit comprising an oscillator circuit, where the sensor capacitance (Ct), forms a link of two or more series connected impedances, which is connected to the capacitance measuring circuit (1), only at the end terminals of the series connection, and where one terminal of the sensor capacitance (Ct), is an end terminal of the series connection which is connected to a constant voltage and the other end terminal of the series connection is connected to a sensing node (Cu), which oscillates with a square wave voltage, in order to maintain constant voltage levels during each of the half-periods, and which at the same time senses the charging current flowing into the series connected impedances, to enable the capacitance measuring circuit to be triggered at the moments when the charging current thus sensed has changed to predetermined levels,
**characterized in that** the complete capacitance measuring circuit, including the sensing node (Cu), is shifted alternately between two voltages (Vdd, Vss).

2. Capacitance measuring circuit according to claim 1, **characterized in that** the series connected impedances, consists of the sensor capacitance (Ct), with one end grounded and the other end connected to the oscillating sensing node (Cu), through a resistor (Rt).

3. Capacitance measuring circuit according to claims 1 or 2, **characterized in that** the circuit contains a current comparator (2) with a sensing node (Cu), which senses the charging current of the capacitance to be measured..

4. Capacitance measuring circuit according to one or more of claims 1 to 3.
**characterized in that** the two voltages, (Vdd, Vss), which define the square wave voltage, impressed on the series connected impedances, are alternately switched to one end of a resistor (R1), which is connected to the sensing node (Cu) at the other end, in order to generate the two reference currents.

5. Capacitance measuring circuit according to one or more of claim 1 to 4,
**characterized in that** the sum of the reference current and the capacitance charging current is essentially zero, when the switching level for the current comparator is reached.

6. Capacitance measuring circuit according to one or more of claims 1 to 5,
**characterized in that** reference currents with appropriate values and polarities are generated internally in the current comparator (2) by current sources which are
switched according to the polarity of the charging current in the series connected impedances.

7. Capacitance measuring circuit according to one or more of claims 1 to 6,
**characterized in that**, the sensing node is connected to a plurality of series connected impedances, including a plurality of sensor capacitances, through a multiplexing circuit.

## Patentansprüche

1. Kapazitanzmesskreis, umfassend einen Oszillatorkreis, wobei die Sensorkapazitanz Ct eine Verbindung zweier oder mehrerer in Reihe geschalteter Impedanzen bildet, die nur an den Endklemmen der Reihenschaltung mit dem Kapazitanzmesskreis 1 verbunden ist, und wobei der eine Anschluss der Sensorkapazitanz Ct eine mit einer konstanten Spannung verbundene Endklemme der Reihenschaltung ist, und die andere Endklemme der Reihenschaltung mit einem Sensorknoten Cu verbunden ist, welcher zur Aufrechterhaltung konstanter Spannungswerte in jeder der Halbperioden mit einer Rechteckspannung oszilliert, und welcher gleichzeitig den in die in Reihe geschalteten Impedanzen hineinfließenden Ladestrom erfasst, um das Triggern des Kapazitanzmesskreises in den Augenblicken, in denen sich der hierdurch erfasste Ladestrom in vorgegebene Werte geändert hat, zu ermöglichen,
**dadurch gekennzeichnet, dass** der vollständige Kapazitanzmesskreis einschließlich des Sensorknotens Cu alternierend zwischen zwei Spannungen Vdd und Vss wechselt.

2. Kapazitanzmesskreis nach Anspruch 1, **dadurch gekennzeichnet, dass** die in Reihe geschalteten Impedanzen aus der Sensorkapazitanz Ct bestehen, wobei das eine Ende geerdet ist, und das andere Ende durch einen Widerstand Rt mit dem oszillierenden Sensorknoten Cu verbunden ist.

3. Kapazitanzmesskreis nach den Ansprüchen 1 oder 2, **dadurch gekennzeichnet, dass** der Stromkreis einen Stromkomparator 2 mit einem Sensorknoten Cu, der den Ladestrom der zu messenden Kapazitanz erfasst, enthält.

4. Kapazitanzmesskreis nach einem oder mehreren der Ansprüche 1 bis 3, **dadurch gekennzeichnet, dass** die beiden Spannungen Vdd und Vss, welche die an den in Reihe geschalteten Impedanzen angelegte Rechteckspannung definieren, alternierend auf das eine Ende eines Widerstands 1 geschaltet werden, der am anderen Ende mit dem Sensorknoten Cu verbunden ist, um die beiden Referenzströme zu erzeugen.

5. Kapazitanzmesskreis nach einem oder mehreren der Ansprüche 1 bis 4, **dadurch gekennzeichnet, dass** die Summe des Referenzstroms und des Kapazitanz-Ladestroms, wenn der Einschaltpegel des Stromkomparators erreicht wird, im Wesentlichen null ist.

6. Kapazitanzmesskreis nach einem oder mehreren der Ansprüche 1 bis 5, **dadurch gekennzeichnet, dass** Referenzströme mit geeigneten Werten und Polaritäten im Innern dieses Stromkomparators 2 durch Stromquellen erzeugt werden, die entsprechend der Polarität des Ladestroms in den in Reihe geschalteten Impedanzen geschaltet sind.

7. Kapazitanzmesskreis nach einem oder mehreren der Ansprüche 1 bis 6, **dadurch gekennzeichnet, dass** der Sensorknoten durch eine Multiplexschaltung mit einer Mehrzahl in Serie geschalteter Impedanzen, einschließlich einer Mehrzahl von Sensor-Kapazitanzen, verbunden ist.

## Revendications

1. Circuit de mesure de capacité comprenant un montage oscillateur, dans lequel la capacité du capteur Ct forme une liaison de deux impédances ou plus connectées en série, qui est raccordée au circuit de mesure de capacité 1 uniquement aux bornes d'extrémité de la connexion en série, et dans lequel une borne de la capacité du capteur Ct est une borne d'extrémité de la connexion en série qui est raccordée à une tension constante et l'autre borne d'extrémité de la connexion en série est raccordée à un noeud de détection Cu qui oscille avec une tension en onde carrée afin de maintenir des niveaux de tension constants au cours de chaque demi-période, et qui en même temps, détecte le courant de charge passant dans les impédances connectées en série pour permettre au circuit de mesure de capacité d'être déclenché aux instants où le courant de charge ainsi détecté est passé à des niveaux prédéterminés,
**caractérisé en ce que** dans le circuit de mesure de capacité complet, incluant le noeud de détection Cu, on alterne entre deux tensions Vdd et Vss.

2. Circuit de mesure de capacité selon la revendication 1, **caractérisé en ce que** les impédances connectées en série sont constituées par la capacité du capteur Ct, avec une extrémité mise à la terre et l'autre extrémité connectée au noeud de détection oscillant Cu, par le biais d'une résistance Rt.

3. Circuit de mesure de capacité selon la revendication 1 ou 2, **caractérisé en ce que** le circuit contient un comparateur de courant 2 avec un noeud de détection Cu, qui détecte le courant de charge de la capacité à mesurer.

4. Circuit de mesure de capacité selon l'une ou plusieurs des revendications 1 à 3, **caractérisé en ce que** les deux tensions Vdd et Vss qui définissent la tension en onde carrée, appliquées sur les impédances connectées en série, sont commutées en alternance à une extrémité d'une résistance R1 qui est connectée au noeud de détection Cu à l'autre extrémité, afin de produire les deux courants de référence.

5. Circuit de mesure de capacité selon l'une ou plusieurs des revendications 1 à 4, **caractérisé en ce que** la somme du courant de référence et du courant de charge de capacité est essentiellement nulle lorsque le niveau de commutation pour le comparateur de courant est atteint.

6. Circuit de mesure de capacité selon l'une ou plusieurs des revendications 1 à 5, **caractérisé en ce que** les courants de référence avec des valeurs et des polarités appropriées sont produits intérieurement dans le comparateur de courant 2 par des sources de courant qui sont commutées en fonction de la polarité du courant de charge dans les impédances connectées en série.

7. Circuit de mesure de capacité selon l'une ou plusieurs des revendications 1 à 6, **caractérisé en ce que** le noeud de détection est connecté à une pluralité d'impédances connectées en série, y compris une pluralité de capacités de capteurs, par un circuit de multiplexage.
